# EUROPEAN PATENT SPECIFICATION

(11) **EP 3 153 258 B1**
(45) Date of publication and mention of the grant of the patent: **06.01.2021**
(21) Application number: 15803141.9
(22) Date of filing: 30.04.2015
(51) Int. Cl.: B23B 27/14, B23B 51/00, B23C 5/16, B23P 15/28, C23C 28/04, C23C 14/02

(54) **METHOD FOR PRODUCING A TOOL FOR MACHINING, AND TOOL FOR MACHINING**
VERFAHREN ZUR HERSTELLUNG EINES BEARBEITUNGSWERKZEUG UND BEARBEITUNGSWERKZEUG
PROCÉDÉ DE PRODUCTION D'UN OUTIL D'USINAGE ET OUTIL D'USINAGE

(30) Priority: 04.06.2014 JP 2014115515
(43) Date of publication of application: 12.04.2017
(73) Proprietor: Kabushiki Kaisha Kobe Seiko Sho (Kobe Steel, Ltd.), Kobe-shi, Hyogo 651-8585 (JP)
(72) Inventor: HIROTA, Satoshi, Takasago-shi, Hyogo 676-8670 (JP)
(74) Representative: TBK
(86) International application number: PCT/JP2015/063047
(87) International publication number: WO 2015/186460

(56) References cited:
- JP-A- S5 435 484
- JP-A- H11 256 310
- JP-A- 2005 153 095
- US-A1- 2001 016 273
- US-A1- 2004 121 147
- Xinyu Wang ET AL: "Mechanical Property and Processing Investigation of Pulsed Laser Deposited Al", Materials, vol. 2004, 1 January 2004 (2004-01-01), pages 147-151, XP055474476, DOI: 10.1115/IMECE2004-61000 ISBN: 978-0-7918-4712-1

## Description

### Technical Field

The present invention relates to a method for producing a tool for machining, and to a tool for machining.

### Background Art

Conventionally, a coating film is formed by physical vapor deposition (thereafter PVD) on the surface of the base material of a tool for machining such as a cutting tool, in order to increase the hardness and wear resistance of the tool.

For instance, a multilayer PVD-coated cutting tool disclosed in Patent Literature 1 is produced through alternate layering, by PVD such as ion plating, of a nitride or carbide of a metal such as titanium (Ti), and aluminum oxide (hereafter alumina), on the surface of a base material.

The layer containing Ti has the function of increasing the hardness and wear resistance of the tool. The alumina layer has the function of preventing oxidation of the layer containing Ti. In a multilayer coating film resulting from alternately laying these layers, the layer containing alumina and the layer containing Ti become worn down sequentially from the tool surface during use of the tool, and then, the remaining alumina layer lying closer to the base material prevents oxidation of the underlying layer containing Ti and the base material.

In a case however where a multilayer coating film is formed through layering of a layer containing Ti and an alumina layer by PVD, as described above, a problem may arise in that adhesion at an interface of the layer containing Ti and the alumina layer is not good.

### Citation of Prior Art

### Patent Literature

Patent Document 1: JP 2001-513708 A
Patent Document 2: US 2004/121147 A1
Patent Document 3: JP 54 35484 A
Patent Document 4: US 2001/0016273 A1

US 2004/121147 A1 discloses an Alumina film on an Oxide film. Further, the Oxide film can be formed on a Mixed Nitride film. An Intermediate layer can be formed between a base object and the Oxide film. Further, the Intermediate layer can be formed after forming the Mixed Nitride film.

In JP 54 35484 A, a method of manufacturing a metal filling fine structure is discussed.

US 2001/0016273 A1 discusses multilayered coating of a plurality of ultrathin CVD coating layers. In particular, several ways and aspects of multilayered coating are discussed. The number of layers can be e.g. 60 to 200. In one embodiment at least two different layers are deposited in a selected order.

### Summary of Invention

An object of the present invention is to provide a method for producing a tool for machining in which defective adhesion of a coating film at an interface of a layer containing titanium and an alumina layer is prevented. Further, a tool shall be provided.

The above object is solved by a method having the features of claim 1. A tool is stated in claim 6. Further developments are stated in the dependent claims.

As a result of exhaustive research to solve the above problem, the inventors found that in a case where a layer containing a nitride or carbide of Ti and a layer of aluminum oxide (alumina) are laminated by PVD, titanium oxide (TiO) is formed at the interface of the layer containing Ti and the alumina layer, this titanium oxide being more brittle than the foregoing layers, and found that the titanium oxide impairs adhesion between the layer containing Ti and the alumina layer at the interface.

Specifically, the inventors found that in a case where the alumina layer is formed by PVD on the layer containing Ti, oxygen gas is fed into a chamber in which PVD is carried out, and hence the surface of the layer containing Ti becomes exposed to the oxygen gas, whereupon Ti reacts with oxygen, and thereby titanium oxide is formed at the interface of the layer containing Ti and the alumina layer.

The inventors arrived at the invention below in order to improve impaired adhesion of a coating film caused by generation of titanium oxide.

Specifically, the method for producing a tool for machining of the present invention is a method for producing a tool for machining in which a coating film of a plurality of layers is formed on the surface of a base material by physical vapor deposition, the method including: a first layer formation step of forming a first layer containing a nitride or carbide of titanium on the surface of the base material; a first barrier layer formation step of forming a barrier layer that covers a surface of the first layer; and a second layer formation step of forming a second layer containing aluminum oxide on a surface of the barrier layer; and a second barrier layer formation step of forming the barrier layer that covers a surface of the second layer after the second layer formation step, wherein a plurality of cycles each including the first layer formation step, the first barrier layer formation step, the second layer formation step and the second barrier layer formation step are continuously performed, to form a multilayer coating film in which the first layer, the second layer and the barrier layer are sequentially laid on each other so that the barrier layer is formed before and after the formation of the second layer, and thereby preventing generation of titanium oxide at an interface with the second layer containing alumina on upper and lower surface sides of the first layer containing Ti.

### Brief Description of Drawings

[Fig. 1] Fig. 1 is an enlarged cross-sectional diagram illustrating an embodiment of a tool for machining produced in accordance with the method for producing a tool for machining of the present invention.
[Fig. 2J Fig. 2 is a plan-view diagram illustrating the basic configuration of a film deposition apparatus that is used in the method for producing a tool for machining of the present invention.

### Description of Embodiments

Embodiments of the method for producing a tool for machining and of the tool for machining of the present invention will be explained next in detail with reference to accompanying drawings.

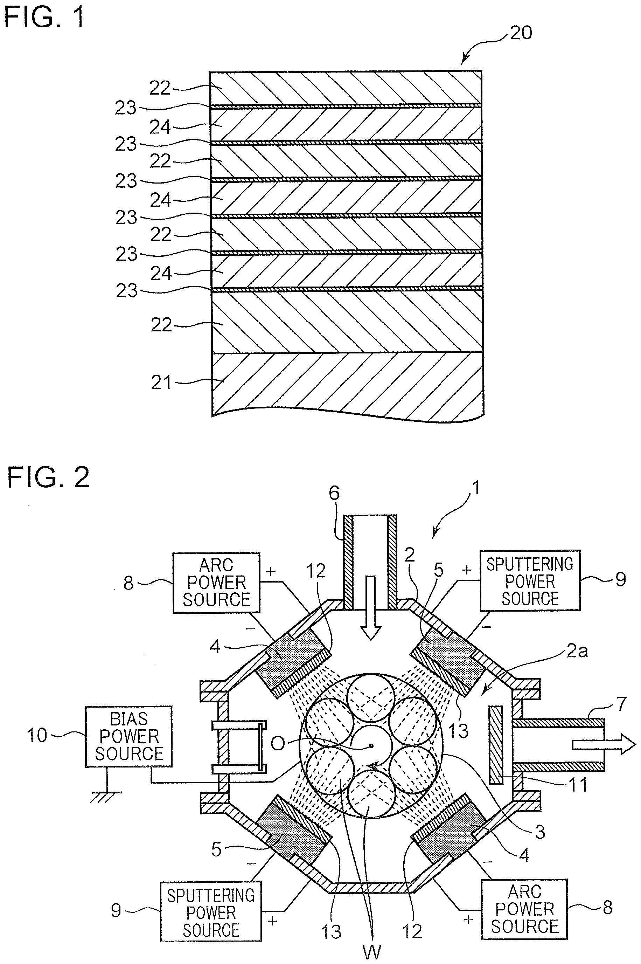

The method for producing a tool for machining of the present embodiment is a method for producing a tool for machining, for instance a cutting tool 20 (for example a drill or end mill) such as the one illustrated in Fig. 1. The present production method is a method in which the cutting tool 20 is produced through formation of a coating film of a plurality of layers (i.e. a first layer 22, a barrier layer 23 and a second layer 24) on the surface of a base material 21, by physical vapor deposition (PVD).

The present production method is a method that involves formation of the barrier layer 23 between a step of forming the first layer 22 containing titanium (Ti) and a step of forming the second layer 24 containing aluminum oxide (alumina), as a result of which there is prevented generation of titanium oxide (TiO) at an interface of the first layer 22 and the second layer 24. The term alumina encompasses for instance Al₂O₃ and amorphous aluminum oxide having no crystal structure.

Specifically, the production method of the cutting tool 20 has: a first layer formation step of forming the first layer 22 containing a nitride or carbide or titanium for instance, a layer made up of titanium aluminum nitride (TiAlN), on the surface of the base material 21; a first barrier layer formation step of forming the barrier layer 23 (for instance, layer made up of aluminum nitride (AlN)) that covers the surface of the first layer 22; and a second layer formation step of forming the second layer 24 containing aluminum oxide (so-called alumina) on the surface of the barrier layer 23.

In order to produce the cutting tool 20 illustrated in Fig. 1, the production method of the present embodiment further has a second barrier layer formation step of forming the barrier layer 23 that covers the surface of the second layer 24, after the second layer formation step. In the present production method, a plurality of cycles each including the first layer formation step, the first barrier layer formation step, the second layer formation step and the second barrier layer formation step, by PVD, are continuously performed, to form as a result a multilayer coating film in which the first layer 22, the barrier layer 23 and the second layer 24 are sequentially laid.

In the present embodiment, the term PVD encompasses various methods, provided that the methods are physical vapor deposition methods that involve depositing a film using a solid target. Examples of PVD in the present embodiment include for instance methods such as ion plating (specifically, arc ion plating (AIP) or the like), magnetron sputtering (specifically, unbalanced magnetron sputtering (UBMS), dual magnetron sputtering (DMS) or the like), arc discharge vapor deposition, and ion beam deposition (IBAD (ion beam assisted deposition)) or the like.

A detailed explanation of a film deposition process by PVD will be described below.

As illustrated in Fig. 1, the cutting tool 20 produced in accordance with the above production method has a structure in which the first layer 22 and the second layer 24 are sequentially laid on the surface of the base material 21, and a respective barrier layer 23 is interposed at the interface of the first layer 22 and the second layer 24. The portions of the cutting tool 20 are configured as follows.

The base material 21 is produced out of a high-hardness material that is utilized for tool production, for instance tungsten carbide (WC).

The first layer 22 is a layer that covers the surface of the base material 21, in order to enhance the hardness and the wear resistance of the cutting tool 20. The first layer 22 is a layer containing a nitride or carbide of titanium, for instance a layer made up of titanium aluminum nitride (TiAIN).

It is sufficient that the first layer 22 is a layer containing a nitride or carbide of titanium. The first layer 22 may be for instance a layer (so-called nano-laminate) in which titanium aluminum nitride and aluminum chromium nitride are mixed and layered at the nano-scale. Alternatively, the first layer 22 may be a layer made up of a carbide of titanium such as titanium carbon nitride (TiCN) or titanium carbide (TiC).

Among the first layers 22, the lowermost first layer, i.e. the first layer 22 that is in contact with the surface of the base material 21, is formed to be thicker than the other first layers 22.

The second layer 24 is a layer that covers the first layer 22 that comprises titanium aluminum nitride, in order to prevent oxidation of the first layer 22. The second layer 24 is a layer containing aluminum oxide (alumina), for instance a layer made up of alumina. The second layer 24 has alumina as a main component, but may contain other components.

In the cutting tool 20 illustrated in Fig. 1, a first layer 22 made up of titanium aluminum nitride having a higher hardness than alumina is disposed at the outermost layer, but this outermost first layer 22 may be omitted.

The barrier layer 23 is a layer interposed between the first layer 22 containing Ti and the second layer 24 containing oxygen. The barrier layer 23 prevents generation of titanium oxide (TiO) at the interface of the first layer 22 and the second layer 24, at the upper and lower surfaces of the first layer 22.

For instance, a layer containing a nitride or carbide of a metal different from titanium is used as the barrier layer 23. The barrier layer 23 made up of a metal nitride or carbide exhibits high hardness, and is thus preferred herein.

In particular, the barrier layer 23 is a layer containing a nitride or carbide of a metal including aluminum. Specifically, the aluminum-containing barrier layer 23 contains aluminum similarly to the second layer 24 that comprises alumina, and has thus a composition similar to that of the second layer 24; accordingly, the barrier layer 23 exhibits good adhesion and affinity towards the second layer 24.

Yet more specifically, the barrier layer 23 is preferably a layer made up of aluminum nitride (AlN). The aluminum target that is used when forming by PVD the second layer 24 made up of alumina can be used in a case where the barrier layer 23 made up of aluminum nitride is formed by PVD.

It is sufficient that the barrier layer 23 is a layer that prevents generation of titanium oxide (TiO) at the interface of the first layer 22 and the second layer 24, and may be a layer made up of aluminum chromium nitride (AlCrN) or chromium nitride (CrN), besides aluminum nitride (AlN).

A film deposition process by PVD for producing the above cutting tool 20 will be explained next with reference to Fig. 2.

The cutting tool 20 is produced using the film deposition apparatus 1 illustrated in Fig. 2.

The film deposition apparatus 1 is an apparatus for forming a coating film of a plurality of layers, by PVD, on the surface of a workpiece W which serves herein as the base material 21 of the cutting tool 20.

Specifically, the film deposition apparatus 1 illustrated in Fig. 2 comprises a vacuum chamber 2, a rotating table 3 on which workpieces W are placed, a plurality (two in Fig. 2) of arc evaporation sources 4 and a plurality (two in Fig. 2) of sputtering evaporation sources 5.

The vacuum chamber 2 has a space 2a in which there are accommodated the rotating table 3 and the workpieces W placed on the rotating table 3. During the film deposition process, the space 2a is kept in vacuum, or in a state near vacuum, by a vacuum pump not shown. In the vacuum chamber 2 there are provided an introduction section 6 for introducing, into the space 2a, gases necessary for the film deposition process, and a discharge section 7 through which gases after the film deposition process are discharged out of the space 2a.

The rotating table 3 is disposed within the space 2a of the vacuum chamber 2. During the film deposition process, the rotating table 3 rotates about a central axis O, in a state where a plurality of workpieces W has been placed on the rotating table 3. The rotating table 3 may be further provided with rotating platforms on which the workpieces W are individually placed, such that each workpiece W can rotate on itself.

The arc evaporation sources 4 are evaporation sources for performing arc ion plating (hereafter, AIP) on the workpieces W, in order to form the first layer 22 made up of titanium aluminum nitride. The arc evaporation sources 4 are, for instance, arc ion plating evaporation sources of cathode discharge type. The arc evaporation sources 4 are connected to the cathodes of arc power sources 8. The anodes of the arc power sources 8 are, for instance, connected to the vacuum chamber 2, but may be connected to some other member. Targets 12 of titanium-aluminum (TiAl) that constitutes the material for forming a film of titanium aluminum nitride are mounted on the arc evaporation sources 4.

The first layer 22 can be formed using sputtering evaporation sources for performing sputtering, instead of using the arc evaporation sources 4. In this case, the sputtering evaporation sources are for instance evaporation sources for performing magnetron sputtering, more specifically dual magnetron sputtering (DMS).

The sputtering evaporation sources 5 are evaporation sources for performing film deposition on the workpieces W by sputtering, in order to form layers other than the first layer 22, namely the barrier layer 23 made up of aluminum nitride and the second layer 24 made up of alumina. The sputtering evaporation sources 5 are, for instance, dual magnetron sputtering (DMS) evaporation sources. The cathodes of sputtering power sources 9 are connected to the sputtering evaporation sources 5. The anodes of the sputtering power sources 9 are, for instance, connected to the vacuum chamber 2, but may be connected to some other member. Targets 13 of aluminum, which constitutes the material for depositing a film of aluminum nitride and alumina, are mounted on the sputtering evaporation sources 5.

The barrier layer 23 and the second layer 24 can be formed using arc evaporation sources that perform AIP, instead of the sputtering evaporation sources 5.

To produce the cutting tool 20 using the film deposition apparatus 1 having the above configuration, the workpieces W made up of tungsten carbide (WC) that constitutes the base material 21 of the cutting tool 20 are firstly placed on the rotating table 3.

Air inside the space 2a of the vacuum chamber 2 is discharged out of the chamber by means of a vacuum pump not shown. At the same time, bias voltage is applied to the workpieces W from a bias power source 10, across the rotating table 3. The rotating table 3 rotates in this state, with the workpieces W placed thereon. The workpieces W on the rotating table 3 are heated by a heater 11.

In this state, firstly the first layer 22 made up of titanium aluminum nitride (TiAlN) becomes formed on the surface of the workpieces W (i.e. on the base material 21) by AIP, using the arc evaporation sources 4. Specifically, nitrogen gas is supplied through the introduction section 6 into the space 2a of the vacuum chamber 2. Simultaneously therewith, high current from the arc power sources 8 is applied to the arc evaporation sources 4. Arc discharge occurs thereupon between the anodes and the targets 12 of titanium-aluminum of the arc evaporation sources 4. As a result of this arc discharge, part of the targets 12 melts, vaporizes and in many cases undergoes metal ionization, and becomes adhered thereby on the workpieces W. The first layer 22 made up of titanium aluminum nitride becomes thus formed on the surface of the workpieces W. Once the film deposition operation of the first layer 22 is complete, the gas inside the chamber 2 is discharged out through the discharge section 7.

Next, the barrier layer 23 made up of aluminum nitride (AlN) is formed on the first layer 22 of the workpieces W through dual magnetron sputtering (DMS); using the sputtering evaporation sources 5. Specifically argon and nitrogen gas are supplied through the introduction section 6 into the space 2a of the vacuum chamber 2. Simultaneously therewith, high voltage is applied from the sputtering power sources 9 to the sputtering evaporation sources 5. Thereupon, argon between the cathodes and the aluminum targets 13 of the sputtering evaporation sources 5 is excited into a plasma state, and the ionized argon strikes the targets 13. Aluminum particles fly thereupon off the targets 13 and become adhered on the workpieces W. The supplied nitrogen gas as well decomposes and ionizes within the argon plasma, and becomes deposited on the surface of the workpieces W together with the aluminum particles; the barrier layer 23 made up of aluminum nitride becomes formed as a result on the surface of the workpieces W.

Next, the second layer 24 made up of alumina (Al₂O₃) is formed on the barrier layer 23 of the workpieces W through UBMS using the sputtering evaporation sources 5, similarly to the barrier layer 23. Specifically, argon and oxygen gas are supplied into the vacuum chamber 2, and high voltage from the sputtering power sources 9 is applied to the sputtering evaporation sources 5. Thereupon, argon between the cathodes and the aluminum targets 13 of the sputtering evaporation sources 5 is excited into a plasma state, and the ionized argon strikes the targets 13. Aluminum particles fly thereupon off the targets 13 and become adhered to the workpieces W. The supplied oxygen gas as well decomposes and ionizes within the argon plasma, and becomes deposited on the surface of the workpieces W together with the aluminum particles; the second layer 24 made up of alumina becomes formed as a result on the surface of the workpieces W.

Sequentially forming thus by PVD the first layer 22, the barrier layer 23 and the second layer 24 allows producing the cutting tool 20 having the multilayer coating film illustrated in Fig. 1.

The cutting tool 20 produced in accordance with the production method of the present embodiment has a multilayer coating film that includes the barrier layer 23, and hence no titanium oxide is generated at the interface of the first layer 22 and the second layer 24. As a result, adhesion of the multilayer coating film in the cutting tool 20 is improved, whereby peeling of the multilayer coating film is rendered unlikelier. The cutting tool 20 produced in accordance with the production method of the present embodiment undergoes no peeling at all for instance in a scratch test (test for assessing the degree of peeling of a coating film through pressing of a hard, sharp tip of diamond or the like against the coating film), also under conditions where peeling of the coating film occurs in a structure having a conventional multilayer coating film (i.e. multilayer structure having no barrier layer).

When performing another peeling test in the form of a test where a conical member (for instance, conical indenter for a Rockwell C test) was pressed against the test target, the coating film peeled off at the periphery of a dent formed by the conical member, in a structure of a conventional multilayer coating film. In the cutting tool 20 of the present embodiment, by contrast, no coating film peeling at all occurs at the periphery of the dent that may form at the portion pressed against by the conical member.

These test results reveal that peeling of a coating film is unlikelier, and adhesion of the multilayer coating film is improved, in the cutting tool 20 produced in accordance with the production method of the present embodiment, as compared with a structure of a conventional multilayer coating film.

The production method of the cutting tool 20 of the present embodiment explained above has the following characterizing features.
(1) In the production method of the cutting tool 20 of the present embodiment, the first layer 22 containing a nitride or carbide containing titanium is formed, by PVD, on the surface of the base material 21, and the surface of the first layer 22 is covered next by the barrier layer 23. Therefore, no titanium oxide is generated even when forming by PVD the second layer 24 containing aluminum oxide (alumina) on the surface of the barrier layer 23. This allows preventing defective adhesion of the coating film at the interface of the first layer 22 containing Ti and the second layer 24 containing alumina.
(2) In the production method of the cutting tool 20 of the present embodiment, a respective barrier layer 23 is formed before and after formation of the second layer 24; accordingly, it becomes possible to prevent generation of titanium oxide at interfaces with an alumina layer on the upper and lower surface sides of a layer containing Ti. As a result, defective adhesion of the multilayer coating film on the surface of the base material 21 can be prevented, and adhesion of the multilayer coating film can be improved.
(3) In the production method of the cutting tool 20 of the present embodiment, the barrier layer 23 contains a nitride or carbide of a metal different from titanium, and has high hardness. Therefore, it becomes possible to suppress drops in hardness on the entire layered portion of the coating film. Further, it becomes possible to prevent occurrence of defective adhesion at the interface of the barrier layer 23 and the second layer 24, without the concern of generation of titanium oxide at the interface. The barrier layer 23 may contain substances other than metals.
(4) In the production method of the cutting tool 20 of the present embodiment, the barrier layer 23 contains a nitride or carbide of a metal including aluminum, and hence exhibits a composition similar to that of the second layer 24 containing aluminum. Adhesion and affinity between the barrier layer 23 and the second layer 24 are further enhanced as a result.
(5) In the production method of the cutting tool 20 of the present embodiment, the barrier layer 23 is made up of aluminum nitride, and hence a shared aluminum target can be used in a case where the barrier layer 23 and the second layer 24 made up of alumina are formed by PVD. This allows reducing the size of the film deposition apparatus for performing PVD.
(6) In the production method of the cutting tool 20 of the present embodiment, the first layer 22 contains titanium aluminum nitride, and hence exhibits a composition similar to that of the barrier layer 23 containing aluminum. Adhesion and affinity between the first layer 22 and the barrier layer 23 are further enhanced as a result. The first layer 22, the barrier layer 23 and the second layer 24 all contain aluminum, and hence there are enhanced adhesion and affinity in the entire layered portion of the foregoing layers.
(7) In the cutting tool 20 produced in accordance with the production method of the present embodiment, the barrier layer 23 is interposed between the first layer 22 and the second layer 24, and hence no titanium oxide is generated at the interface of the first layer 22 and the second layer 24. As a result, this allows preventing defective adhesion of the coating film at the interface of the first layer 22 containing Ti and the second layer 24 containing alumina.

In the above embodiment there is illustrated the cutting tool 20, such as a drill or an end mill, as an example of the tool for machining that is produced in accordance with the production method of the above embodiment, but the present invention is not limited thereto. It is sufficient that the tool for machining produced in accordance with the production method of the present invention is a tool for machining having formed thereon a coating film of a plurality of layers including a first layer containing a nitride or carbide of titanium and a second layer containing aluminum oxide. For instance, the production method of the present invention can be used also to produce tools for machining other than cutting tools, such as tools for grinding and polishing.

The specific embodiments described above encompass mainly an invention having the following features.

The method for producing a tool for machining of the present embodiment is a method for producing a tool for machining in which a coating film of a plurality of layers is formed on a surface of a base material by physical vapor deposition, the method including: a first layer formation step of forming a first layer containing a nitride or carbide of titanium on the surface of the base material; a first barrier layer formation step of forming a barrier layer that covers a surface of the first layer; and a second layer formation step of forming a second layer containing aluminum oxide on a surface of the barrier layer.

By virtue of the above feature, a first layer containing a nitride or carbide that contains titanium is formed on the surface of a base material by physical vapor deposition (PVD), and then the surface of the first layer is covered by a barrier layer. As a result, the titanium in the first layer is not exposed to oxygen gas, being a material for generating the aluminum oxide of the second layer containing aluminum oxide (alumina), on the first layer, even upon formation of the second layer by PVD on the surface of the barrier layer. Therefore, no titanium oxide is generated on the surface of the first layer. This allows preventing defective adhesion of the coating film at the interface of the first layer containing Ti and the second layer containing alumina.

The production method of the present embodiment can be used also in a case where a multilayer coating film is formed through alternate layering of the first layer and the second layer.

In this case, the method further has a second barrier layer formation step of forming the barrier layer that covers a surface of the second layer after the second layer formation step; wherein a plurality of cycles each including the first layer formation step, the first barrier layer formation step, the second layer formation step and the second barrier layer formation step are continuously performed.

The inventors discovered the following features relating to such a multilayer coating film. Specifically, the inventors found that under conditions whereby the tool is in a high-temperature atmosphere, oxygen might desorb from the alumina layer and react with Ti of the layer containing Ti, thereby giving rise to titanium oxide, also at the interface of the alumina layer and the layer containing Ti and that is positioned on the alumina layer, in a case where a multilayer coating film is formed through alternate layering of a layer containing Ti and a layer containing alumina, as in conventional multilayer coating films. Specifically, the inventors found that when forming the multilayer coating film, titanium oxide is generated at the interface with the alumina layer also on the upper and lower surface sides of the layer containing Ti.

In the above characterizing feature, therefore, a barrier layer is formed before and after formation of the second layer, as a result of which it becomes possible to prevent generation of titanium oxide at the interface with the alumina layer on the upper and lower surface sides of the layer containing Ti. In consequence, defective adhesion of the multilayer coating film on the surface of the base material can be prevented, and adhesion of the multilayer coating film can be improved.

Preferably, the barrier layer includes a nitride or carbide of a metal different from titanium. Decreases in hardness on the entire layered portion of the coating film can be thus suppressed since the barrier layer containing a nitride or carbide of a metal has high hardness. Further, the metal is different from titanium, which prevents the generation of titanium oxide at the interface of the barrier layer and the second layer. Accordingly, it becomes possible to prevent defective adhesion at the interface.

Preferably, the barrier layer includes a nitride or carbide of a metal including aluminum. The composition of the barrier layer containing aluminum is similar to that of the second layer containing aluminum; adhesion and affinity of the barrier layer and the second layer are further enhanced as a result.

Specifically, for instance, the barrier layer preferably comprises aluminum nitride. Aluminum is used as a target in a case where the barrier layer is formed by PVD. This aluminum can be used as a target in the formation, by PVD, of the second layer containing aluminum oxide. Accordingly, a shared aluminum target can be used in a case where the barrier layer and the second layer are formed by PVD. This allows reducing the size of the film deposition apparatus for performing PVD.

Preferably, the first layer includes titanium aluminum nitride in a case where the barrier layer includes a nitride or carbide of a metal including aluminum, as described above. The composition of the first layer is similar to that of the barrier layer containing aluminum, and accordingly adhesion and affinity of the first layer and the barrier layer are further enhanced as a result. The first layer, the barrier layer and the second layer all contain aluminum, and hence there are enhanced adhesion and affinity in the entire layered portion of the foregoing layers.

The tool for machining of the present embodiment is characterized by being produced in accordance with the above production method. In this tool for machining, the barrier layer is interposed between the first layer and the second layer, and hence no titanium oxide is generated at the interface of the first layer and the second layer. As a result, this allows preventing defective adhesion of the coating film at the interface of the first layer containing Ti and the second layer containing alumina.

## Claims

1. A method for producing a tool (20) for machining in which a coating film of a plurality of layers is formed on a surface of a base material (21) by physical vapor deposition,
the method comprising:
a first layer formation step of forming a first layer (22) containing a nitride or carbide of titanium on the surface of the base material (21);
a first barrier layer formation step of forming a barrier layer (23) that covers a surface of the first layer (22);
a second layer formation step of forming a second layer (24) containing aluminum oxide on a surface of the barrier layer (23); and
a second barrier layer formation step of forming the barrier layer (23) that covers a surface of the second layer (24) after the second layer formation step, wherein
a plurality of cycles each including the first layer formation step, the first barrier layer formation step, the second layer formation step and the second barrier layer formation step are continuously performed, to form a multilayer coating film in which the first layer (22), the second layer (24) and the barrier layer (23) are sequentially laid on each other so that the barrier layer (23) is formed before and after the formation of the second layer (24), and
thereby preventing generation of titanium oxide at an interface with the second layer containing alumina on upper and lower surface sides of the first layer containing Ti.

2. The method for producing a tool for machining according to claim 1, wherein the barrier layer (23) includes a nitride or carbide of a metal different from titanium.

3. The method for producing a tool for machining according to claim 2, wherein the barrier layer (23) includes a nitride or carbide of a metal including aluminum.

4. The method for producing a tool for machining according to claim 3, wherein the barrier layer (23) includes aluminum nitride.

5. The method for producing a tool for machining according to claim 3 or 4, wherein the first layer (22) includes titanium aluminum nitride.

6. A tool (20) for machining, which is produced by the production method of any one of claims 1 to 5.

## Patentansprüche

1. Verfahren zum Herstellen eines Werkzeugs (20) für ein Bearbeiten, bei dem ein Beschichtungsfilm aus einer Vielzahl an Lagen auf einer Oberfläche eines Basismaterials (21) durch physikalische Gasphasenabscheidung (PVD) ausgebildet wird,
wobei das Verfahren die folgenden Schritte aufweist:
einen ersten Lagenausbildungsschritt zum Ausbilden einer ersten Lage (22), die ein Nitrid oder Karbid aus Titan enthält, auf der Oberfläche des Basismaterials (21);
einen ersten Barrierelagenausbildungsschritt zum Ausbilden einer Barrierelage (23), die eine Oberfläche der ersten Lage (22) bedeckt;
einen zweiten Lagenausbildungsschritt zum Ausbilden einer zweiten Lage (24), die Aluminiumoxid enthält, auf einer Oberfläche der Barrierelage (23); und
einen zweiten Barrierelagenausbildungsschritt zum Ausbilden der Barrierelage (23), die eine Oberfläche der zweiten Lage (24) bedeckt, nach dem zweiten Lagenausbildungsschritt, wobei
eine Vielzahl an Zyklen, die jeweils den ersten Lagenausbildungsschritt, den ersten Barrierelagenausbildungsschritt, den zweiten Lagenausbildungsschritt und den zweiten Barrierelagenausbildungsschritt umfassen, fortlaufend ausgeführt werden, um einen Mehrlagenbeschichtungsfilm auszubilden, bei dem die erste Lage (22), die zweite Lage (24) und die Barrierelage (23) in Aufeinanderfolge übereinander so gelegt sind, dass die Barrierelage (23) vor und nach dem Ausbilden der zweiten Lage (24) ausgebildet wird, und
dadurch ein Erzeugen von Titanoxid an einer Grenzfläche mit der zweiten Lage, die Aluminat enthält, an einer oberen und unteren Flächenseite der ersten Lage, die Ti enthält, verhindert wird.

2. Verfahren zum Herstellen eines Werkzeugs für ein Bearbeiten gemäß Anspruch 1, wobei die Barrierelage (23) ein Nitrid oder Karbid aus einem Metall enthält, das sich von Titan unterscheidet.

3. Verfahren zum Herstellen eines Werkzeugs für ein Bearbeiten gemäß Anspruch 2, wobei die Barrierelage (23) ein Nitrid oder Karbid aus einem Metall enthält, das Aluminium umfasst.

4. Verfahren zum Herstellen eines Werkzeugs für ein Bearbeiten gemäß Anspruch 3, wobei die Barrierelage (23) Aluminiumnitrid umfasst.

5. Verfahren zum Herstellen eines Werkzeugs für ein Bearbeiten gemäß Anspruch 3 oder 4, wobei die erste Lage (22) Titanaluminiumnitrid umfasst.

6. Werkzeug (20) für ein Bearbeiten, das durch das Herstellverfahren gemäß einem der Ansprüche 1 bis 5 hergestellt wird.

## Revendications

1. Procédé pour produire un outil (20) d'usinage dans lequel un film de revêtement ayant une pluralité de couches est formé sur une surface d'un matériau de base (21) par dépôt physique en phase vapeur, le procédé comprenant :
une première étape de formation de couche consistant à former une première couche (22) contenant un nitrure ou carbure de titane sur la surface du matériau de base (21) ;
une première étape de formation de couche de barrière consistant à former une couche de barrière (23) qui couvre une surface de la première couche (22) ;
une deuxième étape de formation de couche consistant à former une deuxième couche (24) contenant de l'oxyde d'aluminium sur une surface de la couche de barrière (23) ; et
une deuxième étape de formation de couche de barrière consistant à former la couche de barrière (23) qui couvre une surface de la deuxième couche (24) après la deuxième étape de formation de couche,
dans lequel une pluralité de cycles comprenant chacun la première étape de formation de couche, la première étape de formation de couche de barrière, la deuxième étape de formation de couche et la deuxième étape de formation de couche de barrière sont effectués en continu, pour former un film de revêtement multicouche dans lequel la première couche (22), la deuxième couche (24) et la couche de barrière (23) sont déposées en séquence les unes sur les autres de façon que la couche de barrière (23) soit formée avant et après la formation de la deuxième couche (24), et
ce qui empêche ainsi la génération d'oxyde de titane au niveau d'une interface avec la deuxième couche contenant de l'alumine sur les côtés des surfaces supérieure et inférieure de la première couche contenant du Ti.

2. Procédé pour produire un outil d'usinage selon la revendication 1, dans lequel la couche de barrière (23) contient un nitrure ou carbure d'un métal différent du titane.

3. Procédé pour produire un outil d'usinage selon la revendication 2, dans lequel la couche de barrière (23) contient un nitrure ou carbure d'un métal comprenant de l'aluminium.

4. Procédé pour produire un outil d'usinage selon la revendication 3, dans lequel la couche de barrière (23) contient du nitrure d'aluminium.

5. Procédé pour produire un outil d'usinage selon la revendication 3 ou 4, dans lequel la première couche (22) contient du nitrure de titane et d'aluminium.

6. Outil (20) d'usinage, qui est produit par le procédé de production de l'une quelconque des revendications 1 à 5.
